Europäisches Patentamt

European Patent Office

Office européen des brevets

(11) Numéro de publication: **0 093 650**
**A1**

(12) **DEMANDE DE BREVET EUROPEEN**

(21) Numéro de dépôt: **83400823.7**

(22) Date de dépôt: **26.04.83**

(51) Int. Cl.³: **G 01 R 33/02**
**H 03 H 2/00**

(30) Priorité: **04.05.82 FR 8207753**

(43) Date de publication de la demande:
**09.11.83 Bulletin 83/45**

(84) Etats contractants désignés:
**DE GB NL SE**

(71) Demandeur: **THOMSON-CSF**
**173, Boulevard Haussmann**
**F-75379 Paris Cedex 08(FR)**

(72) Inventeur: **Castera, Jean-Paul**
**THOMSON-CSF SCPI 173, bld Haussmann**
**F-75379 Paris Cedex 08(FR)**

(72) Inventeur: **Hartemann, Pierre**
**THOMSON-CSF SCPI 173, bld Haussmann**
**F-75379 Paris Cedex 08(FR)**

(74) Mandataire: **Wang, Pierre et al,**
**THOMSON-CSF SCPI 173, Bld Haussmann**
**F-75379 Paris Cedex 08(FR)**

(54) Magnétomètre à ondes magnétostatiques.

(57) L'invention se rapporte aux magnétomètres à ondes magnétostatiques.

L'invention a pour objet un magnétomètre dans lequel les ondes magnétostatiques sont propagées par des couches (2a, 2b) de grenat d'yttrium et de fer substitué au gallium.

L'invention s'applique notamment à la mesure de champs magnétiques de faible intensité.

FIG.4

Croydon Printing Company Ltd.

EP 0 093 650 A1

1

# MAGNÉTOMETRE A ONDES MAGNETOSTATIQUES

La présente invention se rapporte aux magnétomètres à ondes magnéto statiques. Ces magnétomètres sont basés sur le mélange soustractif de deux signaux alternatifs produits par des oscillateurs dont la fréquence d'accord est fonction du champ magnétique à mesurer. L'accord de chaque oscillateur est déterminé par un élément retardateur ou résonateur à ondes magnétostatiques de volume ou de surface construit à partir d'une couche de grenat d'yttrium et de fer (YIG) épitaxiée sur un substrat constitué par un grenat de gadolinium et gallium (GGG). Dans un montage comportant deux oscillateurs à ondes magnétostatiques, des champs magnétiques de polarisation antiparallèles et de mêmes intensités sont appliqués dans deux régions de propagation adjacentes d'une couche magnétique. Des ondes magnétostatiques sont excitées dans ces deux régions grâce à des circuits amplificateurs à très haute fréquence dont les entrées et sorties sont reliées à des transducteurs pour ondes magnétostatiques. En l'absence de champ extérieur, le mélange soustractif des fréquences d'oscillation fournit un signal de sortie à basse fréquence. En présence d'un champ extérieur, la fréquence du signal de sortie varie, car ce champ, qui coexiste dans les deux régions, tend à s'ajouter à l'un des champs de polarisation et à se retrancher à l'autre. Cette variation de fréquence est donc représentative de la composante du champ à mesurer selon la direction d'alignement des champs de polarisation.

Le problème qui se pose est de rendre aussi faibles que possible les fluctuations de fréquence occasionnées par la variation de température. C'est la raison pour laquelle le système de mesure est dédoublé en deux oscillateurs à ondes magnétostatiques présentant des dérives en température qui se compensent l'une l'autre lors du mélange soustractif des fréquences d'oscillation. Cette configuration permet de réduire la dérive de température de trois ordres de grandeur, ce qui aboutit par exemple à une dérive de fréquence ramenée à quelques ppm par degré centigrade. En prenant par exemple un magnétomètre à ondes magnétostatiques de volume progressives (OMVF) réalisé à partir d'une couche de YIG pur, on peut parvenir à une dérive de la fréquence différence de 5 ppm/°C. En exprimant cette dérive thermique en gamma, on trouve une instabilité de 360 $\gamma$ /°C. Cette valeur

importante diminue l'intérêt de ce type de magnétomètre lorsqu'il s'agit d'effectuer des mesures à l'échelle du gamma qui est le cent millième d'Oersted.

Pour pallier cet inconvénient, on peut avoir recours à une enceinte thermostatée et/ou à des configurations qui font appel à quatre régions de mesure et à deux mélanges soustractifs étagés comme décrit dans le brevet · européen N° 0015168. Cependant, ces palliatifs sont relativement complexes à mettre en oeuvre.

La présente invention a pour objet un magnétomètre à ondes magnétostatiques comprenant au moins deux oscillateurs hyperfréquence sensibles aux ondes magnétostatiques, ces derniers comprenant un dispositif monolithique avec chacun une couche de matériau magnétique soumise au champ à mesurer, des moyens électromagnétiques pour soumettre lesdites couches respectivement à des champs magnétiques prédéterminés de même direction, cette direction étant la direction de sensibilité maximale, de sens opposés et d'intensités voisines, lesdits oscillateurs présentent des fréquences d'oscillations voisines ; ledit magnétomètre comprenant en outre des moyens mélangeurs ayant deux entrées respectivement reliées aux oscillateurs pour fournir un signal dont la fréquence est égale à la différence des fréquences d'oscillation des deux oscillateurs et est variable en fonction de la composante du champ à mesurer suivant ladite direction, caractérisé en ce que le matériau magnétique est un grenat d'yttrium et de fer substitué au gallium de formule $Y_3 Fe_{5-x} GGa_x O_{12}$ où le taux de substitution x n'excède pas l'unité.

L'invention sera mieux comprise à l'aide de la description ci-après et des figures annexées parmi lesquelles :

    - la figure 1 représente une configuration de magnétomètre à ondes magnétostatiques de surface selon le brevet européen N° 0015168 ;

    - les figures 2 et 3 sont des figures explicatives ;

    - la figure 4 représente une configuration de magnétomètre à ondes magnétostatiques de volume progressives selon l'invention ;

    - la figure 5 représente une configuration de magnétomètre à ondes magnétostatiques de surface selon l'invention.

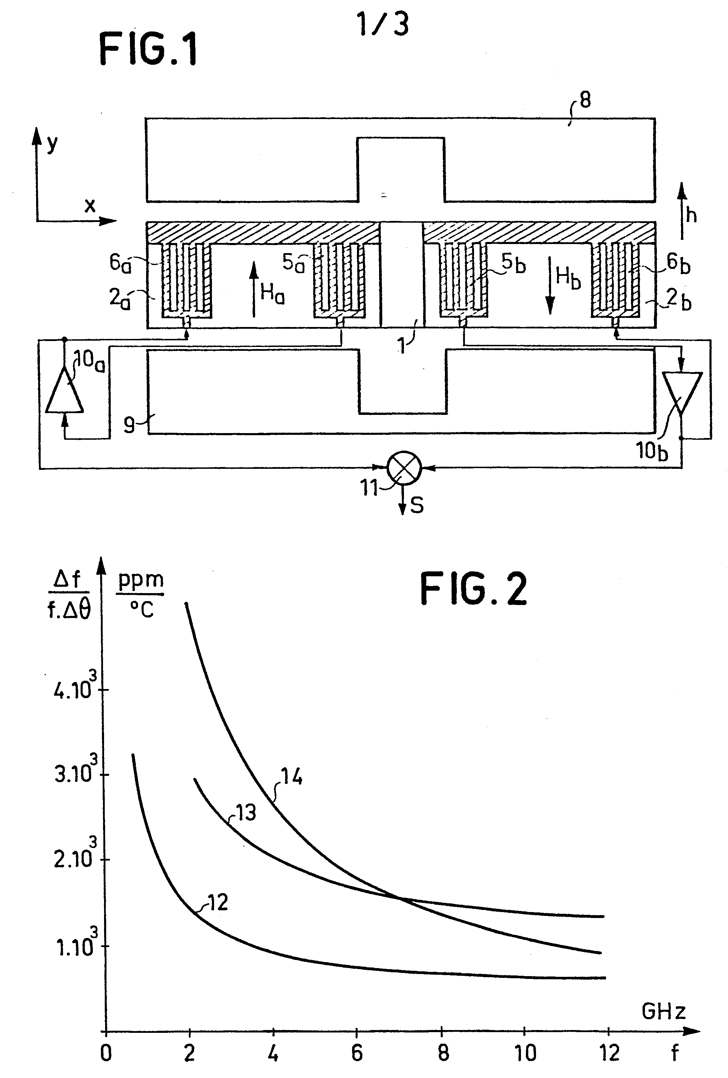

Sur la figure 1, on a représenté un substrat 1 en grenat de gadolinium et gallium dont la surface située dans le plan de figure porte deux éléments de couche magnétique 2a et 2b. La couche magnétique 2a, 2b est d'épaisseur uniforme, par exemple 20 $\mu$m ; elle est obtenue par épitaxie d'un grenat $Y_3 Fe_5 O_{12}$. Les éléments de couche 2a et 2b sont polarisés par des aimants 8 et 9 produisant les champs internes $H_A$ et $H_b$. Comme le montre la figure 1, ces champs internes sont antiparallèles et de même direction que la composante h du champ externe à mesurer. Les champs $H_a$, $H_b$ et h sont tous parallèles à la direction y du plan de figure x, y. L'élément de couche 2a porte une structure conductrice en deux parties 5a et 6a. Les parties 5a et 6a sont des réseaux transducteurs à bandes conductrices rectilignes parallèles à y dont les extrémités sont reliées par une bande de masse commune du côté de l'aimant 8 et par deux connexions d'entrée et de sortie du côté de l'aimant 9. Un amplificateur 10a a sa sortie reliée à la connexion d'entrée de la partie émettrice 6a et son entrée reliée à la connexion de sortie de la partie réceptrice 5a. L'ensemble 2a, 5a, 6a et 10a forme un premier oscillateur à ondes magnétostatiques de surface. Un ensemble similaire 2b, 5b, 6b et 10b forme un second oscillateur à ondes magnétostatiques de surface. Les deux oscillateurs sont raccordés aux deux entrées du mélangeur soustractif 11 qui produit le signal de mesure S.

Les fréquences d'oscillation des deux oscillateurs dépendent du retard de transmission des ondes magnétostatiques de surface. Or, la vitesse de propagation des ondes magnétostatiques dépend de plusieurs paramètres qui sont les champs internes $H_a$ ou $H_b$, l'aimantation à saturation $4 \pi M$ de la couche magnétique et bien entendu le champ à mesurer h. Les champs internes $H_a$ et $H_b$ sont eux-mêmes fonction des champs de polarisation fournis par les aimants 8 et 9 auxquels il faut retrancher le champ démagnétisant et le champ d'anisotropie de la couche magnétique.

On conçoit aisément qu'indépendamment du champ à mesurer, tous les autres paramètres sont sensibles à la température $\theta$ de la couche magnétique et aussi à celle des aimants utilisés.

Le problème de l'abaissement de la dérive thermique $\Delta f/f\Delta \theta$ d'un magnétomètre à ondes magnétostatiques se pose initialement au niveau des deux oscillateurs et des moyens de polarisation magnétiques utilisés. Lorsque les oscillateurs fonctionnent à la fréquence f de 2 GHz et lorsque la couche magnétique utilisée est en YIG pur, on constate que les ondes magnétostatiques de surface donnent lieu à une dérive en fréquence négative qui vaut - 1990 ppm/°C. Cette dérive qui caractérise la couche magnétique proprement dite ne peut être compensée en adoptant des aimants qui introduiraient en sens contraire une dérive suffisante.

Dès lors, pour qu'un magnétomètre soit apte à mesurer de faibles champs magnétiques h, il faut que les champs internes $H_a$ et $H_b$ ne soient pas inutilement grands par rapport au champ h et que le champ démagnétisant lié à l'aimantation à saturation ne soit qu'une fraction aussi réduite que possible du champ de polarisation fourni par les aimants.

L'étude de la dérive thermique de la fréquence d'oscillation d'un oscillateur à ondes magnétostatiques de surface montre qu'il y a avantage à remplacer le YIG pur de formule $Y_3 Fe_5 O_{12}$ par un YIG substitué au gallium de formule $Y_3 Fe_{5-x} Ga_x O_{12}$. A condition d'adopter un taux de substitution x n'excédant pas l'unité, la couche magnétique conserve une largeur de raie H suffisamment étroite pour permettre une propagation sans pertes excessives des ondes magnétostatiques.

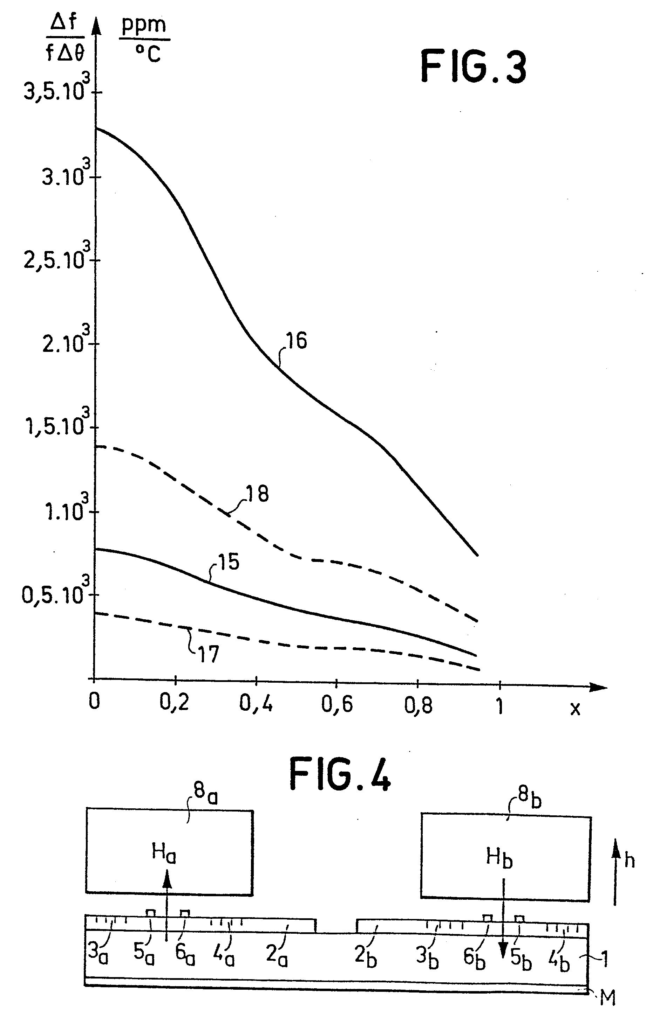

La figure 3 illustre l'avantage apporté par la substitution d'atomes de gallium aux atomes de fer. La dérive thermique $\frac{\Delta f}{f \Delta \theta}$ a sa valeur absolue portée en ordonnée. En abscisse, on a porté le taux de substitution x entre zéro et l'unité. La courbe 17 représente à la fréquence d'oscillation de 13 GHz la relation qui relie la dérive thermique négative au taux de substitution pour des ondes magnétostatiques de surface de longueur d'onde $\lambda$ = 300 $\mu$m propagées par une couche magnétique $Y_3 Fe_{5-x} Ga_x O_{12}$ d'épaisseur d = 20 $\mu$m. IL s'agit de la dérive thermique en fréquence exclusivement dûe à la couche magnétique, c'est-à-dire relevée à polarisation magnétique constante. On voit sur la figure 3 que le YIG pur présente une dérive négative de l'ordre de 400 ppm/°C à 13 GHz. Lorsque le taux de substitution s'approche de l'unité, cette dérive est tombée au quart de sa valeur. La courbe 18 a été relevée dans les mêmes conditions, mais pour une fréquence d'oscillation de 3 GHz. La dérive du YIG pur est d'environ - 1400 ppm/°C et tombe à - 360 ppm/°C pour un taux de substitution x voisin de l'unité.

Les autres courbes de la figure 3 illustrent pour des ondes magnétosta-

5

tiques de volume progressives l'incidence du taux de substitution x sur la dérive thermique en fréquence qui est positive dans ce cas. La courbe 15 a été relevée à la fréquence d'oscillation de 13 GHz et la courbe 16 à la fréquence d'oscillation de 3 GHz.

En raison de ce qui précède, on voit que l'une des caractéristiques de la présente invention est d'utiliser une couche magnétique de formule $Y_3 Fe_{5-x} Ga_x O_{12}$ avec $0 < x < 1$. Ceci s'applique aussi bien aux magnétomètres à ondes magnétostatiques de surface qu'aux magnétomètres à ondes magnétostatiques de volume progressives.

L'utilisation d'une couche magnétique de formule $Y_3 Fe_{5-x} Ga_x O_{12}$ est particulièrement avantageuse dans le cas des magnétomètres à ondes magnétostatiques de volume progressives. En effet, sur la figure 2, on peut voir un diagramme dans lequel on a séparé les causes de dérive thermique de la fréquence d'oscillation selon qu'elles résultent de la couche magnétique en YIG pur ou de la dérive thermique propre des aimants. Il s'agit d'une structure à ondes magnétostatiques de volume progressives du genre de celle de la figure 4. En ordonnée on a porté la dérive $\Delta f / f \Delta \theta$ en valeur absolue et en abscisse la fréquence d'oscillation. La dérive thermique inhérente au YIG pur est positive et est représentée par la courbe 14. Les courbes de dérive relatives à deux aimants au samarium cobalt sont tracées sur la figure 2. La courbe 13 donne la dérive thermique négative en champ H donnée par $\frac{\Delta H}{H \Delta \theta} = - 900$ ppm/°C. La courbe 12 donne la dérive thermique négative propre à un aimant samarium-cobalt présentant une dérive en champ H donnée par $\frac{\Delta H}{H \Delta \theta} = - 400$ ppm/°C.

Compte tenu des signes opposés des dérives thermiques dues à la couche YIG et aux aimants, on voit que l'aimant dont la courbe de dérive est donnée par la courbe 13 permet de compenser exactement la dérive de la couche YIG à la fréquence où les courbes 13 et 14 se croisent. Pour réaliser une compensation de dérive à des fréquences plus élevées, on est amené à produire le champ de polarisation en associant les deux types d'aimants.

L'enseignement de la figure 3 montre que la substitution partielle d'atomes de gallium aux atomes de fer entraîne une diminution de la dérive thermique propre de la couche magnétique. Ainsi, la courbe 14 relative à une couche substituée peut aisément rencontrer la courbe 12 relative à l'aimant le plus facile à se procurer sur le marché. Pour obtenir une compensation de dérive thermique avec un aimant ordinaire et à une fréquence choisie, il suffit d'agir sur le taux de substitution x pour rendre égales en valeur absolue les deux dérives de signes contraires qui caractérisent la couche magnétique et l'aimant de polarisation.

On a vu ci-dessus qu'il est souhaitable que la valeur du champ de polarisation soit la plus faible possible, car le champ magnétique à mesurer s'ajoute et se retranche aux champs $H_a$ et $H_b$. On peut obtenir ce résultat en utilisant des couches de YIG substitué au gallium et au lanthane. Le gallium diminue la valeur de $4\pi M$ et en conséquence la valeur du champ de polarisation.

En ajustant le taux de lanthane, on peut générer un axe d'aimantation facile suivant une direction perpendiculaire au plan de la couche. Dans ce cas, ce sont les contraintes engendrées par le lanthane qui sont à l'origine de cette direction préférentielle de l'aimantation. A titre d'exemple non limitatif, on a mesuré une aimantation $4\pi M$ = 452 Oe avec un matériau de composition $Y_{3-y} La_y Fe_{5-x} Ga_x O_{12}$ avec y = 0,1 et x = 0,7. Pour le YIG pur, l'aimantaion à saturation est 4 M = 1750 Oe.

La figure 4 représente un magnétomètre à ondes magnétostatiques de volume progressives réalisé conformément à la présente invention. Les éléments de couche substituée 2a et 2b sont polarisés par deux aimants 8a et 8b et chacun comporte une cavité de résonance délimitée par des réseaux réflecteurs 3a, 4a et 3b, 4b. Le champ à mesurer h ne subit aucune distorsion dans l'espace, car les matériaux magnétiques sont saturés dans ce mode de réalisation qui ne comporte pas de pièces magnétiques douces pour canaliser le flux de polarisation. Les aimants 8a et 8b produisent des champs internes $H_A$ et $H_b$ aussi égaux que possible bien qu'ils soient antiparallèles et perpendiculaires à la couche magnétique 2a, 2b.

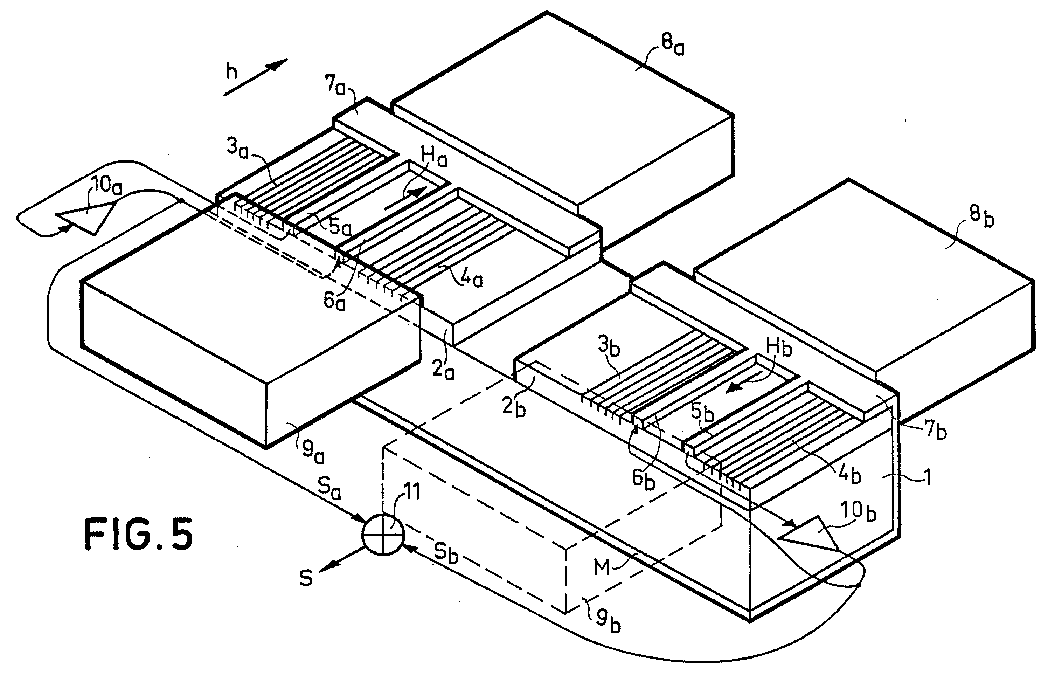

La figure 5 représente un magnétomètre à ondes magnétostatiques de surface à deux résonateurs 3a, 4a et 3b, 4b. Des aimants saturés 8a et 9a créent le champ Ha dans la couche 2a et des aimants saturés 8b et 9b créent le champ $H_b$ anti-parallèle dans la couche 2b. Les couches 2a et 2b sont des couches épitaxiées de YIG substitué au gallium. L'aimant 9b est représenté en pointillé pour rendre plus visibles les liaisons électriques.

# 0093650

7

## REVENDICATIONS

1. Magnétomètre à ondes magnétostatiques comprenant au moins deux oscillateurs hyperfréquence sensibles aux ondes magnétostatiques ; ces derniers comprenant un dispositif monolithique avec chacun une couche de matériau magnétique (2a, 2b), soumise au champ à mesurer (h), des moyens électromagnétiques (8, 9) pour soumettre lesdites couches respectivement à des champs magnétiques prédéterminés de même direction ($H_a$, $H_b$), cette direction étant la direction de sensibilité maximale, de sens opposés et d'intensités voisines, lesdits oscillateurs présentant des fréquences d'oscillation voisines ; ledit magnétomètre comprenant en outre des moyens mélangeurs (11) ayant deux entrées respectivement reliées aux oscillateurs ($10_a$, $10_b$) pour fournir un signal dont la fréquence est égale à la différence des fréquences d'oscillation des deux oscillateurs et est variable en fonction de la composante du champ à mesurer suivant ladite direction.

2. Magnétomètre à ondes magnétostatiques selon la revendication 1, caractérisé en ce que lesdites ondes magnétostatiques étant des ondes magnétostatiques de volume, les champs magnétiques ($H_a$, $H_b$) de même direction et de sens opposés sont produits par des aimants (8a, 8b) présentant une dérive thermique négative ; ledit matériau magnétique (2a, 2b) étant un grenat d'yttrium et de fer substitué au gallium de formule $Y_3 Fe_{5-x} Ga_x O_{12}$ où le taux de substitution x est ajusté pour obtenir une dérive thermique positive sensiblement égale à ladite dérive thermique négative.

3. Magnétomètre à ondes magnétostatiques selon la revendication 2, caractérisé en ce que ledit matériau magnétique (2a, 2b) est un grenat d'yttrium et de fer substitué au gallium et au lanthane de formule $Y_{3-y} Fe_{5-x} Ga_x La_y O_{12}$ où le taux de substitution y est ajusté pour obtenir un axe de facile aimantation dans la direction des champs magnétiques (Ha, Hb).

4. Magnétomètre à ondes magnétostatiques selon la revendication 1, caractérisé en ce que chaque couche (2a, 2b) comprend une cavité résonante à réseaux (3a, 4a, 3b, 4b).

5. Magnétomètre à ondes magnétostatiques selon la revendication 1, caractérisé en ce que chaque couche (2a, 2b) comprend une ligne à retard (5a, 6a, 5b, 6b).

8

6. Magnétomètre à ondes magnétostatiques selon la revendication 1, caractérisé en ce que ladite couche magnétique (2a, 2b) est épitaxiée sur un substrat de grenat de gadolinium et gallium.

0093650

1/3

FIG.1

FIG.2

0093650

# FIG.3

$$\frac{\Delta f}{f \Delta \theta} \quad \frac{ppm}{{}^\circ C}$$

$3,5.10^3$

$3.10^3$

$2,5.10^3$

$2.10^3$ — 16

$1,5.10^3$

$1.10^3$ — 18

$0,5.10^3$ — 15

— 17

0    0,2    0,4    0,6    0,8    1    x

# FIG.4

8a            8b

$H_a$          $H_b$    h

$3_a$   $5_a$   $6_a$   $4_a$   $2_a$     $2_b$   $3_b$   $6_b$   $5_b$   $4_b$   1

M

FIG.5

0093650

0093650
Numéro de la demande

Office européen
des brevets

**RAPPORT DE RECHERCHE EUROPEENNE**

EP 83 40 0823

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| D,Y | FR-A-2 450 462 (THOMSON-CSF) <br> * Revendications 1-9; figures 1,4,5 * | 1,4-6 | G 01 R 33/02 <br> H 03 H 2/00 |
| A | IEEE TRANSACTIONS ON MAGNETICS, vol. MAG-17, no. 6, novembre 1981, pages 2951-2956, IEEE, New York, USA <br> J.D. ADAM et al.: "The status of magnetostatic devices" * Page 2953, colonne 2, lignes 33-60 * | 1-3 | |
| A | GB-A-2 023 569 (ROCKWELL INT. CORP.) <br> * Page 3, ligne 27 - page 4, ligne 32; revendication 9 * | 2,3,6 | |
| A | US-A-3 736 579 (A. MARSH) <br> * Revendications 5,7 * | 2,3,6 | DOMAINES TECHNIQUES RECHERCHES (Int. Cl. ³) |
| A | PATENTS ABSTRACTS OF JAPAN, vol. 5, no. 15 (E-43)[687], 29 janvier 1981 <br> & JP - A - 55 143 009 (MATSUSHITA DENKI SANGYO K.K.) 08-11-1980 * En entier * | 2,6 | G 01 R 33 <br> H 01 F 10 <br> H 03 H 2 |

Le présent rapport de recherche a été établi pour toutes les revendications

| Lieu de la recherche <br> LA HAYE | Date d'achèvement de la recherche <br> 16-08-1983 | Examinateur <br> HAASBROEK J.N. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82